# EUROPÄISCHE PATENTSCHRIFT

(11) **EP 3 430 875 B1**
(45) Veröffentlichungstag und Bekanntmachung des Hinweises auf die Patenterteilung: **11.09.2019**
(21) Anmeldenummer: 17721164.6
(22) Anmeldetag: 04.05.2017
(51) Int. Cl.: H01R 9/26, H05K 7/14

(54) **ELEKTRONISCHE REIHENKLEMME FÜR EINEN DATENBUS**
ELECTRONIC TERMINAL BLOCK FOR A DATA BUS
BLOC DE JONCTION ÉLECTRONIQUE POUR BUS DE DONNÉES

(30) Priorität: 04.05.2016 DE 102016108321
(43) Veröffentlichungstag der Anmeldung: 23.01.2019
(73) Patentinhaber: Beckhoff Automation GmbH, 33415 Verl (DE)
(72) Erfinder: BECKHOFF, Hans, 33415 Verl (DE); JOST, Michael, 32694 Dörentrup (DE); PODROUSCHEK, Martin, 33790 Halle (DE)
(74) Vertreter: Patentanwaltskanzlei WILHELM & BECK
(86) Internationale Anmeldenummer: PCT/EP2017/060669
(87) Internationale Veröffentlichungsnummer: WO 2017/191261

(56) Entgegenhaltungen:
- EP-A1- 1 484 511
- DE-A1- 4 402 002

## Beschreibung

Die Erfindung betrifft eine elektronische Reihenklemme für einen Datenbus mit einer Steuerelektronik, die eine erste und eine zweite elektrische Kontaktiereinrichtung, die über eine interne Stromleitung verbunden sind, eine erste und eine zweite Datenbus-Kontaktiereinrichtung, die über eine interne Datenbusleitung verbunden sind, und eine Anschlusseinrichtung zum Anschließen von Busteilnehmern aufweist.

Diese Patentanmeldung beansprucht die Priorität der deutschen Patentanmeldung 10 2016 108 321.6.

In der Automatisierungstechnik werden elektronische Reihenklemmen, die im Folgenden auch als Busklemmen bezeichnet werden, eingesetzt, um Sensoren und Aktoren, die über analoge und digitale Ein- und Ausgänge unterschiedliche Signale liefern beziehungsweise anfordern, ohne weitere Verdrahtung über einen Feldbus mit einer Steuereinheit zu verbinden. Die elektronischen Reihenklemmen dienen dazu, die unterschiedlichen Signale der Sensoren zu bündeln und mittels eines einheitlichen Bussignals zur Steuereinheit weiterzuleiten, beziehungsweise die Steuerbefehle der Steuereinheit in entsprechende Signale für die Aktoren umzusetzen und an diese weiterzugeben.

Die elektronischen Reihenklemmen werden dabei oft als Busklemmenstation auf einer gemeinsamen Trageschiene zusammengefasst, wobei als Kopfstelle ein Buskoppler vorgesehen ist, der als Schnittstelle zum Feldbus dient und die elektronischen Reihenklemmen an die Steuereinheit anbindet. Die Kommunikation zwischen den Buskopplern und den einzelnen elektronischen Reihenklemmen erfolgt über einen internen Klemmenbus, wobei die Busklemmenverbindung kabellos über Kontakte durchgeführt wird.

Busklemmenstationen erlauben in der Regel das Aneinanderreihen von elektronischen Reihenklemmen mit unterschiedlichsten Signalarten. Auch besteht die Möglichkeit, die Busklemmenstation nachträglich mit weiteren Busklemmen zu erweitern. Einzelne elektronische Reihenklemmen können weiterhin mit einer eigenen Intelligenz versehen sein, um Steuerungsaufgaben dezentral auch ohne Eingriff der Steuereinheit auszuführen. Ferner kann die Busklemmenstation auch spezielle Reihenklemmen aufweisen, die die Antriebe eines Automatisierungssystems direkt ansteuern können.

Aus der gattungsgemäßen DE 44 02 002 A1 ist eine Busklemmenstation bekannt, bei der elektronische Reihenklemmen auf eine Trageschiene aufrastbar sind. Die einzelnen Reihenklemmen weisen dabei interne Datenbus- und Stromversorgungsleitungen auf, die durch das Klemmengehäuse hindurchgeschleift werden, wobei an den Gehäuse-Seitenflächen jeweils Kontakte für die Datenbusleitung und die Stromleitung vorgesehen sind. Durch Zusammenschieben der Reihenklemmen auf der Trageschiene werden die Kontakte zwischen den Reihenklemmen automatisch verbunden, so dass sich durchgehende Datenbus- und Versorgungsleitungen bilden. Eine ähnliche Reihenklemme ist in der EP 1484 511 A1 beschrieben.

Elektronischen Reihenklemmen werden in der Regel mit einem Gehäuse aus Kunststoff gefertigt. Im Bereich der Prozesstechnik ist es aufgrund von Schirmungen und Wärmeentwicklungen vielfach jedoch nicht möglich, solche elektronischen Reihenklemmen aus Kunststoff zur Messwerterfassung einzusetzen. Unter der Bezeichnung imc CRONOSflex (http://www.imc-berlin.de/fileadmin/Public/Products/2014-Brochures/german2014/imc_CRONOSflex_de_2014_08_dp.pdf) ist eine Busklemmenstation bekannt, bei der die elektrischen Reihenklemmen ein Metallgehäuse besitzen, was den Einsatz auch in einem schwierigen Prozessumfeld ermöglicht. Das selbsttragende Metallgehäuse der elektronischen Reihenklemmen weist dabei seitlich verlängerte Front- und Rückplatten auf, die einen Klickmechanismus bilden, um die elektronischen Reihenklemmen im Rahmen der Busklemmenstation miteinander zu verbinden. Die Datenbus- und Stromleitungskontakte sind in den seitlich überstehenden Rückplatten angeordnet und werden beim Zusammenbau mit den entsprechenden Kontakten benachbarter Reihenklemmen zusammengesteckt. Beim imc CRONOSflex-System ergeben sich aber Lücken zwischen den zusammengesteckten elektronischen Reihenklemmen, was die Baugröße der Busklemmenstation erhöht. Der Klickmechanismus beim Zusammenbau macht es außerdem erforderlich, beim Erweitern der Busklemmenstation die weiteren elektronischen Reihenklemmen immer seitlich an die bereits vorhandenen elektronischen Reihenklemmen anzureihen, so dass die Anordnung der elektronischen Reihenklemmen nicht flexibel geändert werden kann.

Aufgabe der vorliegenden Erfindung ist es, eine elektronische Reihenklemme für einen Datenbus und eine Busklemmenstation bereitzustellen, die sich durch einen kompakten und flexiblen Aufbau auszeichnen und auch in einer schwierigen Prozessumgebung, insbesondere, was die Schirmung und Wärmeentwicklung betrifft, eingesetzt werden können.

Diese Aufgabe wird mit einer elektronischen Reihenklemme gemäß Anspruch 1 beziehungsweise mit einer Busklemmenstation gemäß Anspruch 15 gelöst. Bevorzugte Weiterbildungen sind in den abhängigen Ansprüchen angegeben.

Eine elektronische Reihenklemme für einen Datenbus weist eine Steuerelektronik auf, die eine elektrische Kontaktiereinrichtung, die über eine interne Stromleitung verbunden sind, eine Datenbus-Kontaktiereinrichtung, die über eine interne Datenbusleitung verbunden sind, und eine Anschlusseinrichtung zum Anschließen von Busteilnehmern umfasst. Die Steuerelektronik ist dabei in einem Metallgehäuse angeordnet, das eine Gehäuse-Seite mit einer Aufnahme für eine Trageschiene, eine Gehäuse-Seite mit einer Aussparung für die Anschlusseinrichtung der Steuerelektronik und eine Gehäuse-Seitenflächen aufweist. Die Gehäuse-Seitenfläche weist eine erste Öffnung für die Datenbus-Kontaktiereinrichtung und eine zweite Öffnung für die elektrische Kontaktiereinrichtung auf. Es ist weiter eine Kopplungsplatte zum Anbringen auf der Gehäuse-Seitenfläche vorgesehen, die eine erste Aussparung mit einem Eingriff im Bereich der ersten Öffnung der Gehäuse-Seitenfläche und eine zweite Aussparung mit einem Eingriff im Bereich der zweiten Öffnung der Gehäuse-Seitenfläche aufweist. Die Kopplungsplatte ist dabei aus einem nicht-metallischen Werkstoff, vorzugsweise aus einem elektrischen Isolierstoff gefertigt.

Bei der elektronischen Reihenklemme können eine erste und eine zweite elektrische Kontaktiereinrichtung über die interne Stromleitung und eine erste und eine zweite Datenbus-Kontaktiereinrichtung über die interne Datenbusleitung verbunden sein. Eine erste Gehäuse-Seitenfläche weist dann eine erste Öffnung für die erste Datenbus-Kontaktiereinrichtung der Steuerungselektronik und eine zweite Öffnung für die erste elektrische Kontaktiereinrichtung der Steuerungselektronik auf. Eine zweite, der ersten Gehäuse-Seitenfläche gegenüberliegende Gehäuse-Seitenfläche weist eine erste Öffnung für die zweite Datenbus-Kontaktiereinrichtung der Steuerungselektronik und eine zweite Öffnung für die zweite elektrische Kontaktiereinrichtung der Steuerungselektronik auf. Eine ersten Kopplungsplatte zum Anbringen auf der ersten Gehäuse-Seitenfläche weist eine erste Aussparung mit einem Eingriff im Bereich der ersten Öffnung der ersten Gehäuse-Seitenfläche und eine zweite Aussparung mit einem Eingriff im Bereich der zweiten Öffnung der ersten Gehäuse-Seitenfläche auf. Eine zweite Kopplungsplatte zum Anbringen auf der zweiten Gehäuse-Seitenfläche weist eine erste Aussparung mit einem Eingriff im Bereich der ersten Öffnung der zweiten Gehäuse-Seitenfläche und eine zweite Aussparung mit einem Eingriff im Bereich der zweiten Öffnung der zweiten Gehäuse-Seitenfläche auf. Die erste und die zweite Kopplungsplatte bestehen aus dem nicht-metallischen Werkstoff, vorzugsweise dem elektrischen Isolierstoff.

Die Auslegung der Reihenklemme mit einem Metallgehäuse, an dem seitlich Kopplungsplatten aus elektrischem Isoliermaterial angeordnet sind, ermöglicht eine kompakte Busklemmenstation, bei der die Reihenklemmen Seite an Seite dicht gepackt angeordnet sind. Das Metallgehäuse sorgt für eine Abschirmung der Steuerelektronik gegen einfallende Strahlung, insbesondere auch magnetische Strahlung. Darüber hinaus ermöglicht das Metallgehäuse einen Abtransport der Abwärme der Steuerelektronik. Die Kopplungsplatten wiederum sorgen für eine elektrische Isolierung zwischen den einzelnen elektronischen Reihenklemmen.

Durch die Öffnungen in den Gehäuse-Seitenflächen und entsprechenden zugeordneten Öffnungen in den Kopplungsplatten besteht die Möglichkeit einer steckbaren Verdrahtung sowohl der internen Stromleitung als auch der internen Datenleitung über die im Metallgehäuse angeordnete Kontakte. Die im Bereich der Aussparung der Kopplungsplatten vorgesehenen Eingriffe, die auf die Öffnungen in den zugehörigen Gehäuse-Seitenflächen abgestimmt sind, sorgen für eine Isolierung, vorzugsweise eine elektrische Isolierung der Kontakte der elektronischen Reihenklemmen gegenüber dem Metallgehäuse. Die elektronischen Reihenklemmen lassen sich auch in beliebiger Anordnung, unbesehen von der jeweilig zugeordneten Funktionalität, das heißt der Signalzusammenstellung der Reihenklemmen, im Rahmen einer Busklemmenstation mischen und auch erweitern. Jede elektronische Reihenklemme in einer Busklemmenstation kann dabei in einfacher Weise durch eine andere elektronische Reihenklemme ersetzt beziehungsweise ganz aus dem Verbund durch Herausziehen der elektronischen Reihenklemme und Zusammenschieben der anderen elektronischen Reihenklemmen herausgenommen werden.

Die Kopplungsplatten sind so ausgebildet, dass die eine Kopplungsplatte zwei seitlich vorstehende c-förmige Schienen zum Eingriff in Schlitze und die andere Kopplungsplatte zwei seitliche Schlitze zum Eingriff in die c-förmige Schienen aufweist. Mit dieser Auslegung der Kopplungsplatten besteht die Möglichkeit, beim Zusammenbau von elektronischen Reihenklemmen im Rahmen einer Busklemmenstation die Reihenklemmen durch Einschieben in die Busklemmenstation zu integrieren beziehungsweise durch Herausziehen aus dem Verbund der Busklemmenstation zu entfernen.

Die erste elektrische Kontaktiereinrichtung weist wenigstens einen Kontaktstift und die zweite elektrische Kontaktiereinrichtung weist wenigstens eine Kontaktöffnung auf. Der Eingriff der zweiten Aussparung der ersten Kopplungsplatte erstreckt sich zwischen dem Kontaktstift und der zweiten Öffnung der ersten Gehäuse-Seitenfläche. Der Eingriff der zweiten Aussparung der zweiten Kopplungsplatte erstreckt sich zwischen der Kontaktöffnung und der zweiten Öffnung der zweiten Gehäuse-Seitenfläche. Mit dieser Auslegung kann eine einfache elektrische Kontaktierung der Stromleitungskontakte zwischen benachbarten elektronischen Reihenklemmen hergestellt werden, wobei die Eingriffe an den Kopplungsplatten für eine zuverlässige galvanische Trennung der durchschleiften Stromleitung vom umgebenen Metallgehäuse sorgen.

Die zweite Aussparung der ersten Kopplungsplatte ist dabei als Schlitzloch in einem nach außen quer über die Kopplungsplatte verlaufenden Führungsschlitz ausgebildet. Mit dieser Auslegung besteht die Möglichkeit, die Kontaktierung durch einfaches Zusammenschieben der elektronischen Reihenklemmen entlang der Kopplungsplatten auszuführen.

Der Eingriff der ersten Aussparung der ersten Kopplungsplatte fixiert die erste Datenbus-Kontaktiereinrichtung und der Eingriff der ersten Aussparung der zweiten Kopplungsplatte fixiert die zweite Datenbus-Kontaktiereinrichtung. Durch die Fixierung der beiden Datenbus-Kontaktiereinrichtungen der elektronischen Reihenklemme wird für eine sichere Kontaktierung mit einer benachbarten elektronischen Reihenklemme gesorgt, um den Datenbus durch die elektronische Reihenklemme durchzuschleifen.

Die erste und die zweite Kopplungsplatte weisen jeweils eine dritte Aussparung zum Eingriff eines Querkontaktes auf die Gehäuse-Seitenfläche auf. Mit der Querkontaktierung besteht die Möglichkeit, einen Potentialausgleich zwischen benachbarten elektronischen Reihenklemmen herzustellen, um so Störspannungen zu vermindern.

Weiterhin ist ein Thermosockel vorgesehen, der die Steuerelektronik mit dem Metallgehäuse verbindet und für ein verbessertes Ableiten der Wärme aus der Steuerelektronik sorgt. Zusätzlich ist es dabei hilfreich, wenn zwei sich gegenüberliegende Seitenflächen jeweils ein Lüftungsfenster aufweisen, wodurch sich ein verbesserter Wärmeabtransport aus dem Metallgehäuse erreichen lässt.

An der Gehäuse-Frontseite kann angrenzend ein Schraubadapter vorgesehen sein. Diese Erweiterung ermöglicht es auf einfache Weise Kabel an die elektronische Reihenklemme heranzuführen.

Das Metallgehäuse ist vorzugsweise aus Guss gefertigt oder gefräst, was eine einfache und kostengünstige Herstellung ermöglicht. Alternativ kann auch ein 3D Druck Verfahren eingesetzt werden, um eine individuell an die Raumerfordernisse angepasste Herstellung zu ermöglichen.

Eine Busklemmenstation setzt sich aus einem Buskoppler und mehreren elektronischen Reihenklemmen zusammen, die nebeneinander auf einer Trageschiene anordenbar sind, wobei wenigstens eine elektronische Reihenklemme auf die vorstehend erläuterter Weise ausgebildet sein kann. Eine solche Busklemmenstation zeichnet sich durch einen kompakten Aufbau aus, der in beliebiger, auch rauer Umgebung eingesetzt werden kann. Hierbei besteht die Möglichkeit elektronische Reihenklemme mit einem Metallgehäuse und seitlichen Kopplungsplatten aus elektrisch isolierendem Material auch mit Reihenklemmen, deren Gehäuse aus Kunststoff gefertigt ist, zu verbinden.

Die Erfindung wird im Folgenden anhand der Zeichnungen erläutert.
Fig. 1 zeigt eine elektronische Reihenklemme in perspektivischer Ansicht von vorne rechts.
Fig. 2 zeigt die elektronische Reihenklemme aus Fig. 1 in einer seitlichen Ansicht von rechts.
Fig. 3 zeigt die elektronische Reihenklemme aus Fig. 1 in einer seitlichen Ansicht von links.
Fig. 4 zeigt die elektronische Reihenklemme aus Fig. 1 in einer Ansicht von vorne.
Fig. 5 zeigt die elektronische Reihenklemme aus Fig. 1 in einer Ansicht von hinten.
Fig. 6 zeigt die elektronische Reihenklemme aus Fig. 1 in einer Ansicht von oben.
Fig. 7 zeigt die elektronische Reihenklemme aus Fig. 1 in einer Ansicht von unten.
Fig. 8 zeigt die elektronische Reihenklemme aus Fig. 1 in einer Explosionsdarstellung.
Fig. 9 zeigt die Kopplungsplatte rechts der elektronischen Reihenklemme aus Fig. 1 in einer perspektivischen Ansicht von außen.
Fig. 10 zeigt die Kopplungsplatte rechts der elektronischen Reihenklemme aus Fig. 1 in einer seitlichen Ansicht von innen.
Fig. 11 zeigt die Basiswanne mit Kopplungsplatte rechts der elektronischen Reihenklemme aus Fig. 1 in einer perspektivischen Ansicht von außen.
Fig. 12 zeigt die Basiswanne mit Kopplungsplatte rechts der elektronischen Reihenklemme aus Fig. 1 in einer seitlichen Ansicht von innen.
Fig. 13 zeigt die Kopplungsplatte links der elektronischen Reihenklemme aus Fig. 1 in einer seitlichen Ansicht von außen.
Fig. 14 zeigt die Kopplungsplatte links der elektronischen Reihenklemme aus Fig. 1 in einer perspektivischen Ansicht von innen.
Fig. 15 zeigt den Basisdeckel mit Kopplungsplatte links der elektronischen Reihenklemme aus Fig. 1 in einer seitlichen Ansicht von außen.
Fig. 16 zeigt den Basisdeckel mit Kopplungsplatte links der elektronischen Reihenklemme aus Fig. 1 in einer perspektivischen Ansicht von innen.
Fig. 17 zeigt eine weitere elektronische Reihenklemme mit Thermosockel, wobei ein Ausschnitt eines Querschnitts durch die elektronische Reihenklemme dargestellt ist.
Fig. 18 zeigt eine Busklemmenstation mit einem Buskoppler und acht elektronischen Reihenklemmen.

Im Folgenden werden für gleiche Merkmale gleiche Bezugszeichen verwendet. In den Figuren können auch der Übersicht halber nicht immer sämtliche Bezugszeichen und/oder sämtliche Merkmale eingezeichnet sein.

Elektronische Reihenklemmen werden verwendet, um analoge und digitale Ein- und Ausgänge zu verdrahten und über einen Feldbus mit einer Steuerung zu verbinden. Die elektronischen Reihenklemmen werden üblicherweise im Rahmen von Busklemmenstationen eingesetzt, bei denen mehrere elektronische Reihenklemmen zusammengeschaltet und über einen Buskoppler mit dem Feldbus verbunden sind. Busklemmenstationen werden in der industriellen Automatisierungstechnik benötigt, können jedoch auch auf anderen Gebieten, wie zum Beispiel in der Gebäudeautomatisierung verwendet werden. Die einzelnen elektronischen Reihenklemmen können dabei jeweils für spezielle digitale und/oder analoge Signalformen ausgelegt sein. An die Reihenklemmen lassen sich dabei beliebige intelligente Sensoren und Aktoren anschließen.

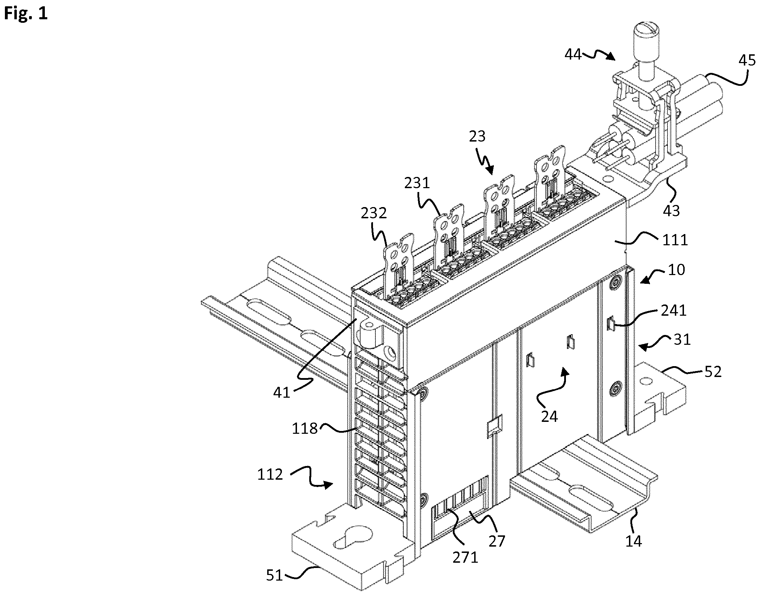

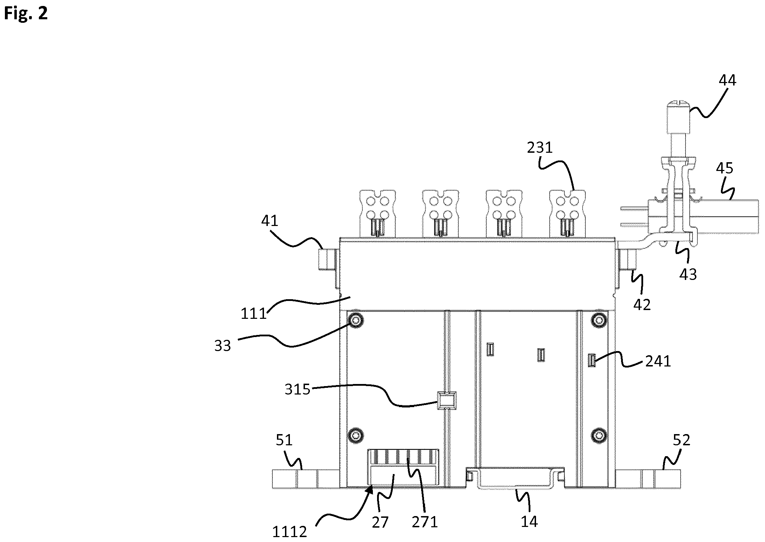

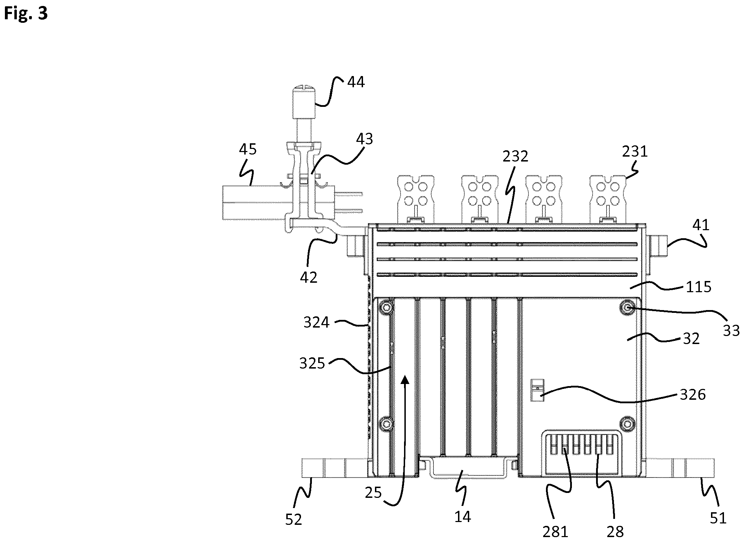

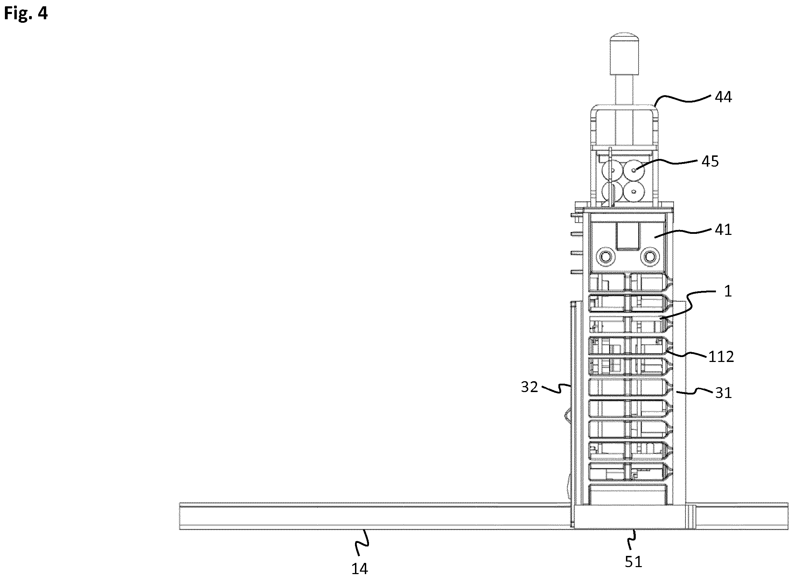

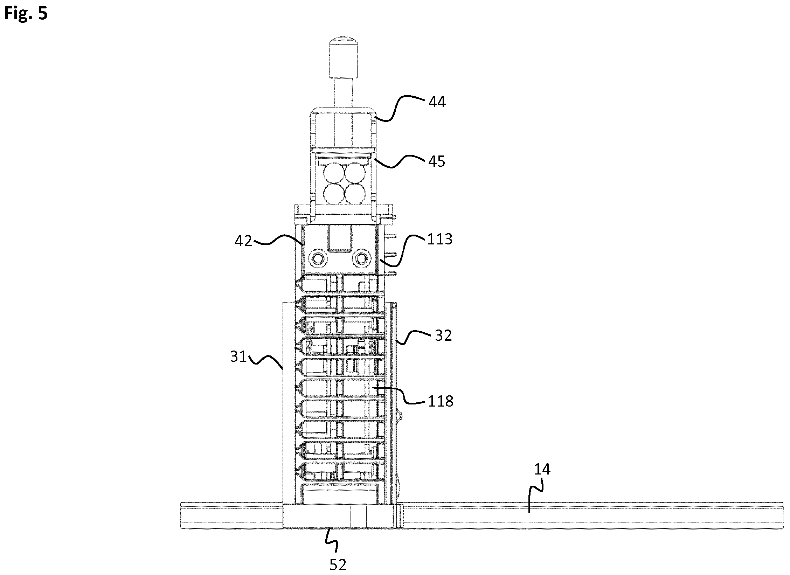

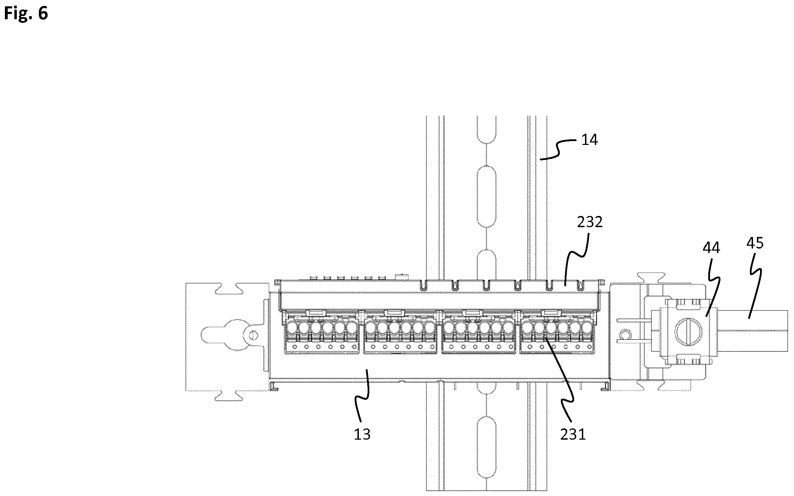

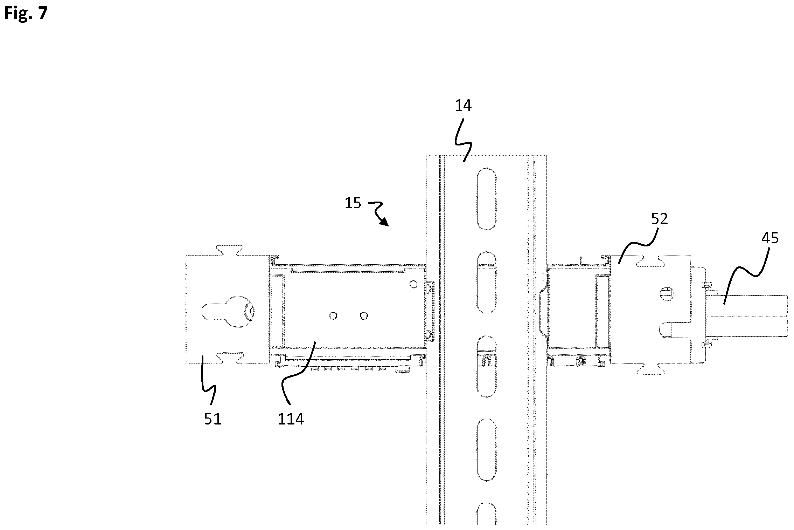

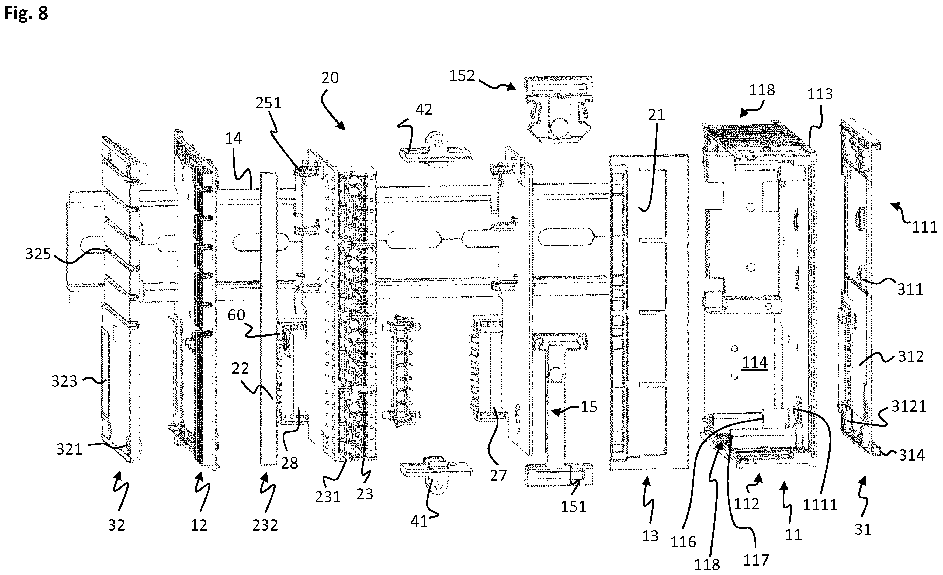

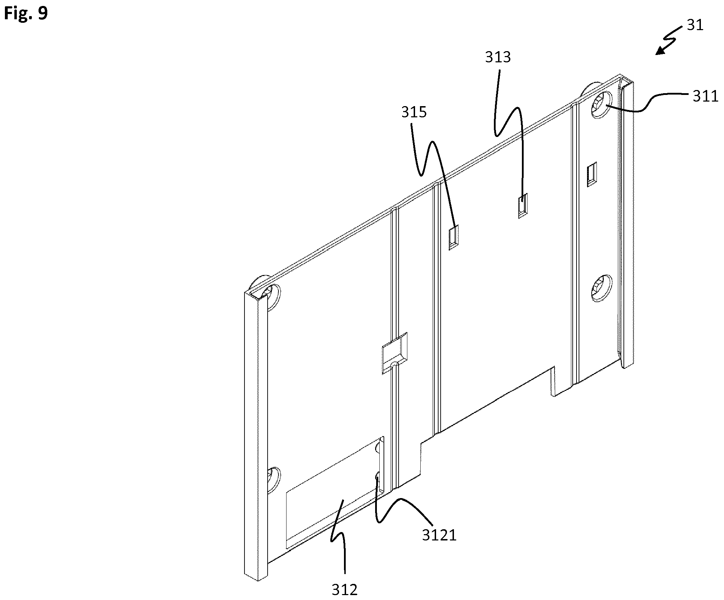

Die Fig. 1 bis 16 zeigen eine Ausführungsform einer elektronischen Reihenklemme. Fig. 1 stellt dabei die elektronische Reihenklemme in perspektivischer Ansicht von schräg vorne rechts dar. Die Fig. 2 und 3 geben jeweils die seitlichen Ansichten von rechts und links wieder. Der Fig. 4 ist eine Ansicht von vorne und der Fig. 5 eine Ansicht von hinten zu entnehmen. Die Ansichten von oben und unten sind in den Fig. 6 und 7 dargestellt. Die Fig. 8 ist eine Explosionsdarstellung der elektronischen Reihenklemme, wobei die Zerlegung in Komponenten ausgehend von der Abbildung der elektronischen Reihenklemme in Fig. 1 erfolgt ist. In den Fig. 9 bis 16 sind einzelne Komponenten aus der Explosionsdarstellung gezeigt.

Die elektronische Reihenklemme weist ein Metallgehäuse 10 auf. Das Metallgehäuse 10 setzt sich aus einer Basiswanne 11, einem Basisdeckel 12 und einem Frontdeckel 13 zusammen. Die Basiswanne 11 umfasst die rechte Gehäuse-Seitenfläche 111, die obere und untere Gehäuse-Seitenfläche 112, 113 und den Rückseitendeckel 114 und ist einstückig ausgebildet. Der Basisdeckel 12 bildet die linke Gehäuse-Seitenfläche 115. Das Metallgehäuse 10 hat dabei die Form eines rechteckigen Kastens. Es besteht jedoch die Möglichkeit, das Metallgehäuse 10 mit einer beliebigen Außenform zu fertigen.

Im Metallgehäuse 10 ist eine Steuerelektronik 20 angeordnet, die auf eine rechte Leiterkarte 21 und eine linke Leiterkarte 22 aufgeteilt ist. Die rechte und die linke Leiterkarte 21, 22 sind aufrecht stehend nebeneinander in der Basiswanne 11 angeordnet. Zur Sicherung der Leiterkarten 21, 22 in dem Metallgehäuse 10 sind in der Basiswanne 11 auf der rechten Gehäuse-Seitenfläche 111 beziehungsweise am Basisdeckel 12 jeweils Verschraubungsdome 116 vorgesehen, auf die die Leiterkarten 21, 22 aufgeschraubt sind. Je nach Auslegung der elektronischen Reihenklemme und Bauraumgröße des Metallgehäuses 10 besteht dabei die Möglichkeit, mehr oder weniger Leiterkarten im Metallgehäuse anzuordnen. Auch können die Bauelemente der Steuerelektronik statt auf Leiterkarten auch auf anders ausgestalteten Trägern, die dann im Metallgehäuse untergebracht beziehungsweise befestigt sind, angebracht sein.

Die Steuerelektronik 20 weist weiter eine Steckerleiste 23 auf, die auf der linken Leiterkarte 22 der Steuerelektronik 20 aufgesteckt und angeschraubt ist. Die Steckerleiste 23 besitzt auf ihrer Oberseite vier Steckplätze 231 für Sensorbeziehungsweise Aktoranschlüsse. Es besteht die Möglichkeit, je nach Auslegung der elektronischen Reihenklemme beziehungsweise der Baumraumgröße, mehr oder weniger Steckplätze vorzusehen. Anstatt von Steckplätzen können auf der Steckerleiste 23 auch anders ausgestaltete Anschlüsse, zum Beispiel Klemmen in Form der so genannten Cage-Clamp-Technologie (auch als Federkraftklemme bekannt) vorgesehen sein. Die Anzahl der Anschlusskanäle pro Steckplatz kann dabei entsprechend der Anzahl der Ein- und Ausgangssignale der anzuschließenden Sensoren beziehungsweise Aktoren gewählt werden.

Auf der Steckerleiste 23 ist weiter entlang der Steckplätze 231 ein LED-Prisma 232 vorgesehen, mit dem die Aktivität der elektronischen Reihenklemme, insbesondere die Signaleingabe- und -ausgabe über die Steckplätze angezeigt werden kann. Die Steckerleiste 23 der Steuerelektronik 20 wird vom Frontdeckel 13 teilweise abgedeckt, wobei der Frontdeckel 13 eine seitliche Aussparung aufweist, durch die die Steckplätze 231 der Steckerleiste 23 hervorstehen. In die Aussparung im Frontdeckel 13 ist weiterhin das LED-Prisma 232 eingelassen.

Die Basiswanne 11, der Basisdeckel 12 und der Frontdeckel 13 sind über an der Basiswanne 11 beziehungsweise am Frontdeckel 13 angebrachte weitere durchgehende Verschraubungsdome 117 miteinander befestigt. In der Basiswanne 11 sind an der oberen und unteren Gehäuse-Seitenfläche 112, 113 Lüftungsschlitzgitter 118 ausgeführt, um die Abwärme der Steuerelektronik 20 aus dem Metallgehäuse 10 abzuführen.

Die Steuerelektronik 20 weist eine rechte elektrische Kontaktiereinrichtung 24 und eine linke elektrische Kontaktiereinrichtung 25 auf, die über eine interne Stromleitung verbunden sind, um eine Stromversorgung durch die elektronische Reihenklemme durchzuschleifen. Die Stromversorgung erfolgt dabei in Dreileitertechnik. Die rechte elektronische Kontaktiereinrichtung 24 ist auf der rechten Leiterkarte 21 in Form dreier vorstehender Kontaktstifte 241 ausgeführt. Die linke elektrische Kontaktiereinrichtung 25 ist auf der linken Leiterkarte 22 angeordnet und weist drei U-förmige Kontaktbuchsen 251 auf, die sich zur Aufnahme von Kontaktstiften 241 der rechten Kontaktiereinrichtung 24 eignen.

Die interne Stromleitung verbindet die drei Kontaktstifte 241 der rechten Kontaktiereinrichtung 24 auf der rechten Leiterkarte 21 mit den U-förmigen Kontaktbuchsen 251 der linken Kontaktiereinrichtung 25 auf der linken Leiterkarte 22, wenn die Leiterkarten 21, 22 sich in den dafür vorgesehenen Positionen im Metallgehäuse 10 befinden. Die interne Stromleitung ist wiederum vorzugsweise als Kontaktstift-Kontaktbuchsenanordnung ausgelegt, wobei U-förmigen Kontaktbuchsen der internen Stromleitung auf der den außen liegenden Kontaktstiften 241 der rechten Kontaktiereinrichtung 24 gegenüber liegenden Innenseite der rechten Leiterkarte 21 ausgeführt sind. Ferner befinden sich Kontaktstifte der internen Stromleitung auf der Innenseite der linken Leiterkarte 22 und sind mit den außen liegenden U-förmigen Kontaktbuchsen 251 der linken Kontaktiereinrichtung 25 verbunden. Beim Zusammenbau greifen die Kontaktstifte der internen Stromleitung auf der rechten Leiterkarte 21 dann in die U-förmigen Kontaktbuchsen der internen Stromleitung auf der linken Leiterkarte 22 ein und sorgen so für eine Stromdurchleitung.

Die Steuerelektronik 20 weist weiterhin eine rechte Datenbuskontaktierung 27 und eine linke Datenbuskontaktierung 28 auf, mit der ein Datenbus durch die elektronische Reihenklemme hindurch geschleift werden kann. Die rechte und linke Datenbuskontaktierung 27, 28 sind jeweils als Kontaktblock ausgeführt und am unteren Rand der rechten bzw. linken Leiterkarte 21, 22 angeordnet.

Die rechte Datenbuskontaktierung 27, die mit der rechten Leiterkarte 21 in Verbindung steht, weist auf ihrer Außenseite als Kontaktiereinrichtung, wie die Ansicht von rechts in Fig. 2 zeigt, Kontaktstege 271 auf. Auf der linken Datenbuskontaktierung 28, die der linken Leiterkarte 22 zugeordnet ist, sind auf der Außenseite Federdruckbügel 281 als Kontaktiereinrichtung vorgesehen, die entsprechend den Kontaktstegen 271 auf der rechten Datenbuskontaktierung 27 ausgerichtet sind, wie die Ansicht von links in Fig. 3 zeigt. Die rechte und linke Datenbuskontaktierung 27, 28 können steckbar miteinander gekoppelt werden und bilden, wenn die rechte Leiterkarte 21 mit dem rechten Datenbuskontaktierung 27 und die linke Leiterkarte 22 mit der linken Datenbuskontaktierung 28 im Metallgehäuse 10 positioniert sind, eine durchgehende interne Datenbusleitung.

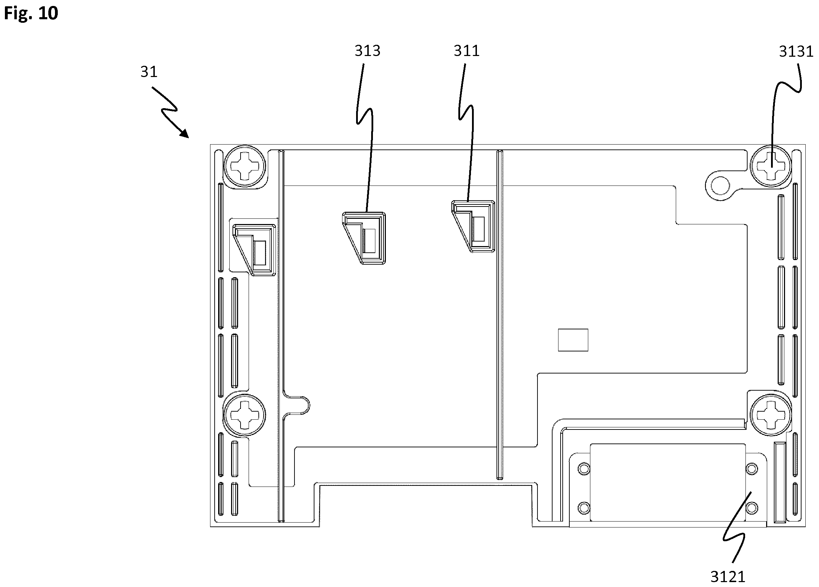

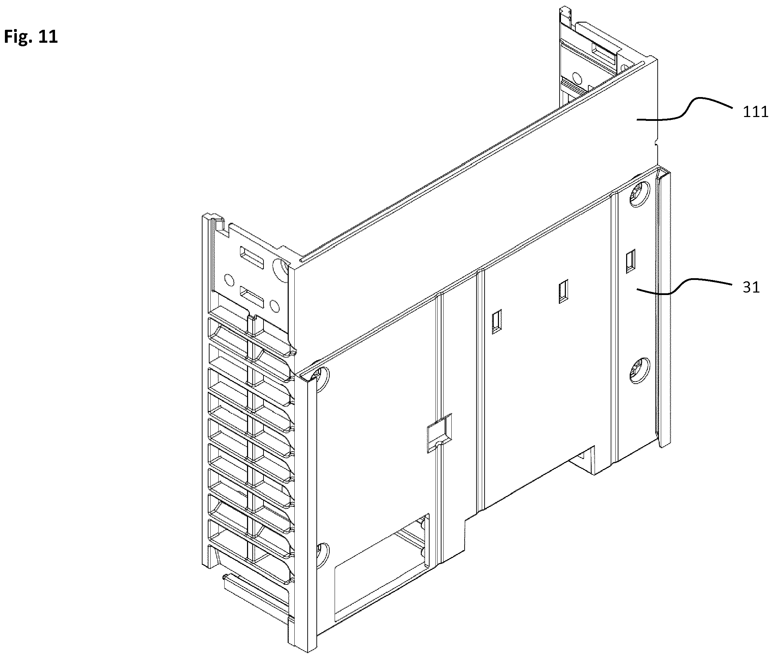

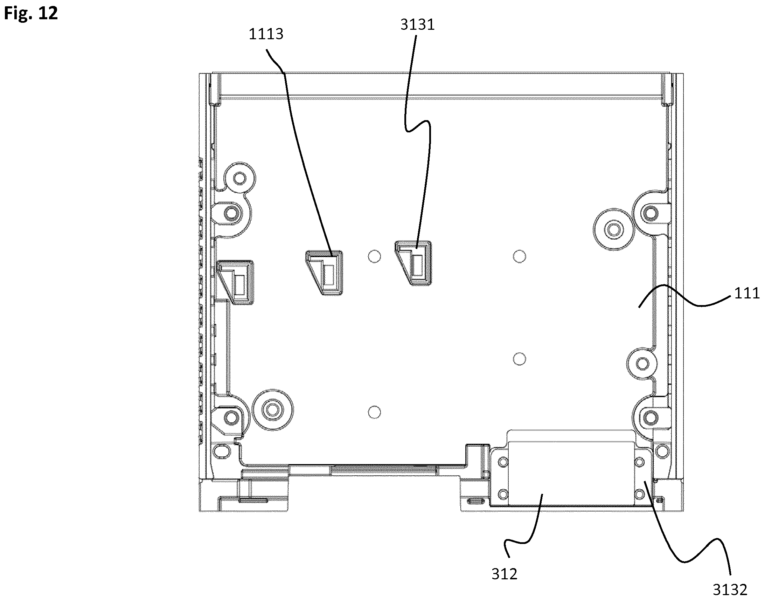

Die elektronische Reihenklemme weist, wie die Explosionsdarstellung in Fig. 8 weiter zeigt, auf der rechten Gehäuse-Seitenfläche 111 der Basiswanne 11 und der linken Gehäuse-Seitenfläche 115 des Basisdeckels 12 jeweils eine Kopplungsplatte 31, 32 auf. Die rechte Kopplungsplatte 31 ist in einer perspektivischen Ansicht von außen in Fig. 9 und in einer Aufsicht von innen in Fig. 10 dargestellt. Die Basiswanne 11 mit aufgesetzter rechter Kopplungsplatte 31 ist in perspektivischer Ansicht von außen in Fig. 11 und in einer Aufsicht von innen in Fig. 12 gezeigt.

Die rechte Kopplungsplatte 31 weist auf der Innenseite vier Schraublöcher 311 zur Aufnahme von Schrauben 33 auf, die in zugeordnete Einschrauböffnungen 1111 auf der rechten Gehäuse-Seitenfläche 111 eingeschraubt werden können. Die Schraublöcher 311 auf der rechten Kopplungsplatte 31 sind auf der Außenseite verbreitert und auf der Innenseite domförmig ausgebildet, um die Schrauben 33 in der rechten Kopplungsplatte 31 versenkt anordnen zu können und so auch bei eingesetzten Schrauben 33 eine plane Oberfläche auf der Außenseite der rechten Kopplungsplatte 31 bereitzustellen. Die Schraubdome der Schraublöcher 311 in der rechten Kopplungsplatte 31 greifen ferner in ebenfalls domförmig ausgebildeten zugeordnete Einschrauböffnungen 1111 in der rechten Gehäuse-Seitenfläche 111 ein und sorgen so für ein gutes Positionieren der rechten Kopplungsplatte 31 auf der rechten Gehäuse-Seitenfläche 111 bei der Montage.

Alternativ zu einer Schraubbefestigung der rechten Kopplungsplatte 31 auf der rechten Gehäuse-Seitenfläche 111 der Basiswanne 11 besteht auch die Möglichkeit, die Kopplungsplatte 31 durch anders gestaltete Befestigungen auf der rechten Gehäuse-Seitenfläche 111 lösbar zu befestigen. Alternativ kann jedoch auch eine feste Verbindung zum Beispiel durch Aufkleben der rechten Kopplungsplatte 31 auf der rechten Gehäuse-Seitenfläche 111 hergestellt werden.

In der rechten Gehäuse-Seitenfläche 111 der Basiswanne 11 ist eine rechteckige Öffnung 1112 vorgesehen, aus der die rechte Datenbuskontaktierung 27 der rechten Leiterkarte 21 mit ihrer Außenseite, auf der die Kontaktstege 271 angeordnet sind, vorsteht, wenn die rechte Leiterplatte 21 im Metallgehäuse 10 positioniert ist, wie die Ansicht von rechts in Fig. 2 zeigt. Die rechte Kopplungsplatte 31 weist im Bereich der rechteckigen Öffnung 1112 der rechten Gehäuse-Seitenfläche 111 eine entsprechende rechteckige Aussparung 312 in der rechten Kopplungsplatte 31 auf, wobei, wie die Ansicht von innen in Fig. 12 zeigt, die rechteckige Aussparung 312 eine vorstehende Umfassung 3121 aufweist, der sich in die rechteckige Öffnung 1112 in der rechten Gehäuse-Seitenfläche 111 erstreckt.

Die rechte Gehäuse-Seitenfläche 111 der Basiswanne 11 weist weiter drei als Durchlässe ausgebildete Öffnungen 1113 auf, auf die in der rechten Kopplungsplatte 31 drei Schlitzöffnungen 313 abstimmt sind, durch sich die drei Kontaktstifte 214 der rechten elektrischen Kontaktiereinrichtung 24 auf der rechten Leiterkarte 21, wenn die rechte Leiterplatte 21 im Metallgehäuse 10 positioniert ist, wie die Ansicht von rechts in Fig. 2 zeigt, erstrecken. Die drei Schlitzöffnungen 313 der rechten Kopplungsplatte 31 sind mit vorstehenden Umfassungen 3131 versehen, die in die Durchlässe 1113 der rechten Gehäuse-Seitenfläche 111 eingreifen, wie die Ansicht von innen in Fig. 12 zeigt. Mit dieser Auslegung kann eine zuverlässige galvanische Trennung der durchgesteckten Kontaktstifte 241 vom umgebenen Metallgehäuse erreicht werden.

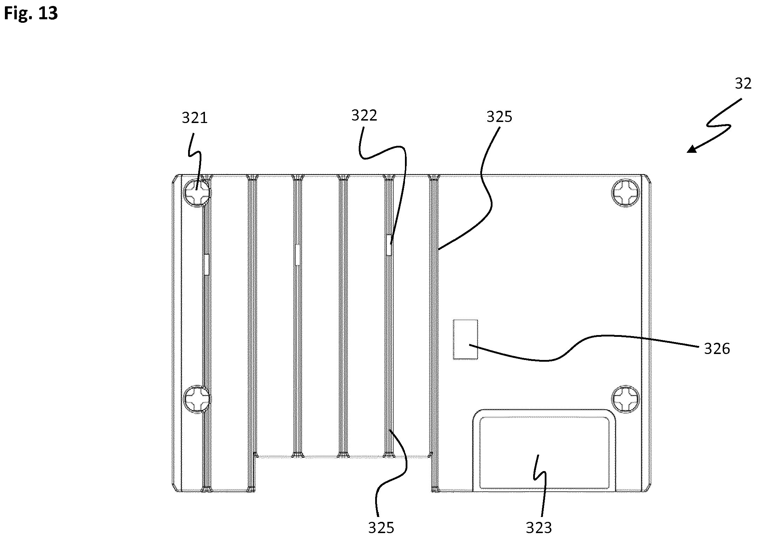

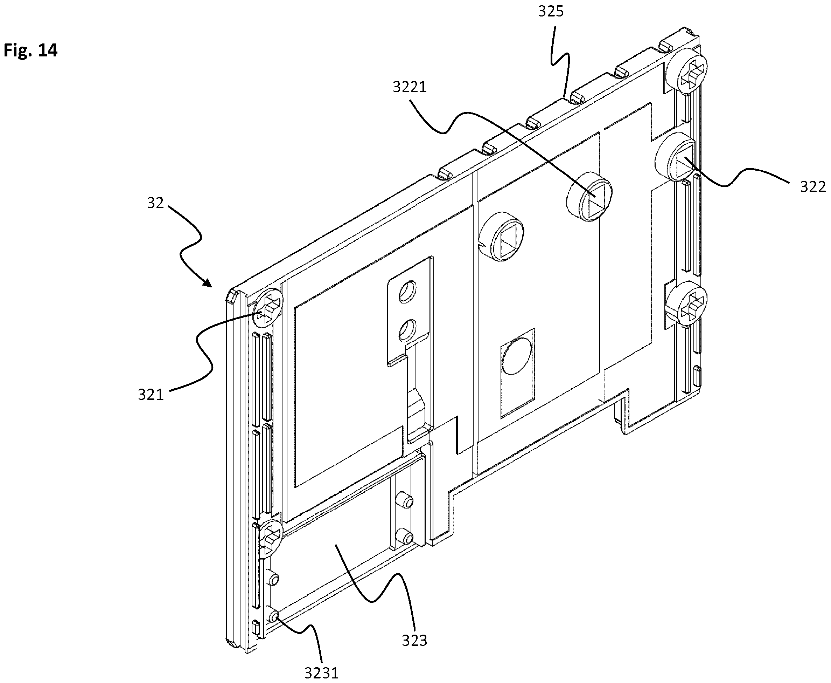

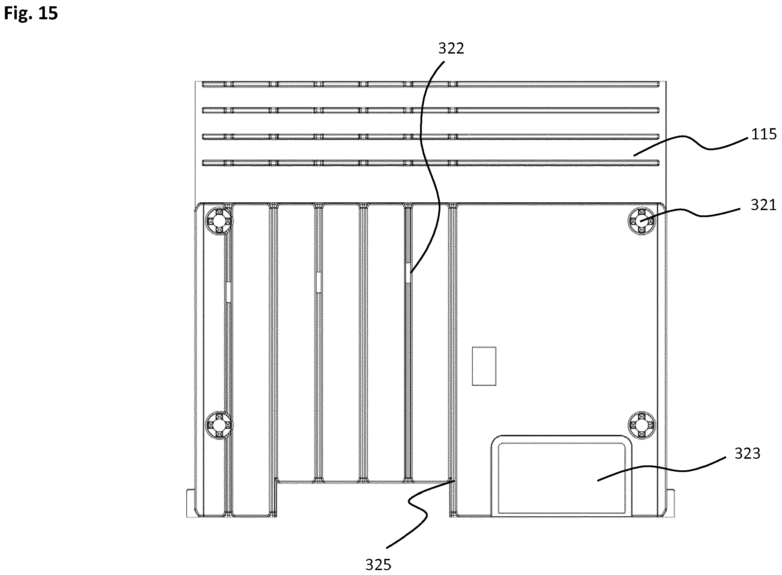

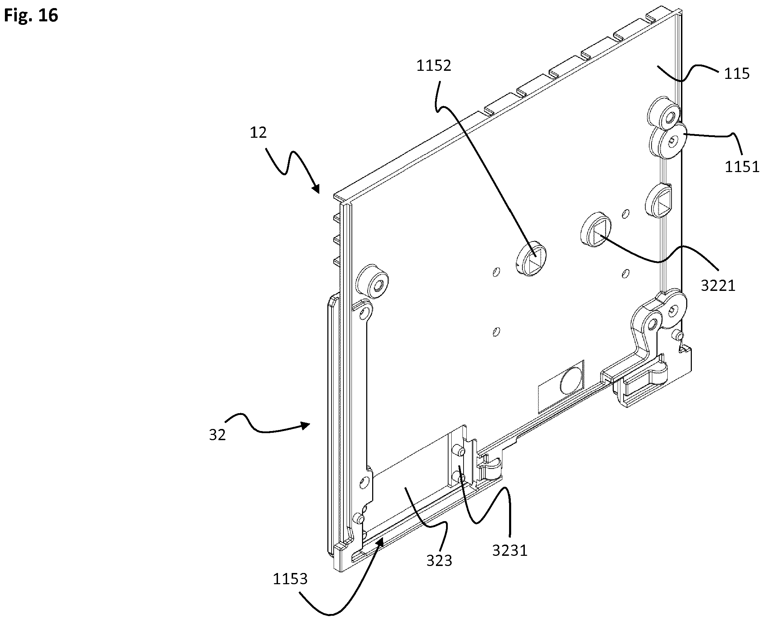

Die linke Kopplungsplatte 32 zum Anbringen auf dem linken Basisdeckel 12, der die linke Gehäuse-Seitenfläche 115 darstellt, ist in einer Aufsicht von innen in Fig. 13 und in einer perspektivischen Ansicht von außen in Fig. 14 dargestellt. Der Basisdeckel 12 mit aufgesetzter linker Kopplungsplatte 32 ist in einer Aufsicht von innen in Fig. 15 und in perspektivischer Ansicht von außen in Fig. 16 gezeigt.

Die linke Kopplungsplatte 32 weist wiederum vier Schraublöcher 321 mit Innendom auf, die in entsprechende Einschraubdome 1151 am Basisdeckel 12 eingreift. Mit Schrauben 33, die in der linken Kopplungsplatte 32 versenkt anordnet sind, so dass sich eine plane Oberfläche auf der Außenseite der linken Kopplungsplatte 32 ergibt, kann die linke Kopplungsplatte 32 auf dem Basisdeckel 12 befestigt werden. Alternative Befestigungen, wie bereits in Zusammenhang mit der rechten Kopplungsplatte 31 erläutert, sind jedoch möglich.

Abgestimmt auf drei als Durchlässe ausgebildete Öffnungen 1152 im linken Basisdeckel 12 sind drei Aussparungen 322 für die Kontaktbuchsen 251 der linken elektrischen Kontaktiereinrichtung 25 in der linken Kopplungsplatte 32 vorgesehen. Die drei Aussparungen 322 weisen wiederum nach innen vorstehende Umfassungen 3221 auf, die die Aussparungen umranden und in die entsprechenden Durchlässe 1152 im linken Basisdeckel 12 eingreifen. Wenn die linke Leiterplatte 22 im Metallgehäuse 10 positioniert ist und die Kontaktbuchsen 251 sich durch die drei Durchlässe 1152 im linken Basisdeckel 12, wie in der Ansicht von links in Fig. 3 gezeigt ist, erstrecken, werden die Kontaktbuchsen 251 der linken elektrischen Kontaktiereinrichtung 25 durch die Umfassungen 1152 vom umgebenen Metallgehäuse abgeschirmt.

In der linken Gehäuse-Seitenfläche 115, die durch den Basisdeckel 12 gebildet wird, ist eine rechteckige Öffnung 1153 vorgesehen, in der die linke Datenbuskontaktierung 28 der linken Leiterkarte 22 mit den Federdruckbügeln 281 als Kontaktiereinrichtung auf der Außenseite angeordnet ist. Die linke Kopplungsplatte 32 weist im Bereich der rechteckigen Öffnung 1153 der linken Gehäuse-Seitenfläche 115 eine entsprechende rechteckige Aussparung 323 auf. Wie die perspektivische Ansicht in Fig. 16 zeigt, ist an der rechteckigen Aussparung 323 einen vorstehenden Umfassung 3231 vorgesehen, die sich in die rechteckige Öffnung 1153 in der linken Gehäuse-Seitenfläche 115 erstreckt.

Das Metallgehäuse 10 ist vorzugsweise aus Guss gefertigt oder gefräst, was eine einfache kostengünstige Herstellung ermöglicht. Alternativ kann auch ein 3D Druck Verfahren eingesetzt werden, um eine individuell an die Raumerfordernisse angepasste Herstellung zu ermöglichen. Durch die Verwendung eines Metallgehäuses kann eine effektive Abschirmung insbesondere gegen magnetische Störungen erreicht werden. Zugleich sorgt der Corpus aus Metall für eine verbesserte Wärmeableitung der Steuerelektronik 20. Die rechte und linke Kopplungsplatte 31, 32 sind dagegen aus einem aus einem nicht-metallischen Werkstoff vorzugsweise einem elektrischen Isolierstoff, insbesondere aus einem Kunststoff, gefertigt.

Mit den Eingriffen an den Öffnungen in den Kontaktplatten 31, 32, insbesondere den vorstehenden Umfassungen 3131, 3221 der Schlitzöffnungen 313 und der Aussparungen 322 für die Kontaktstifte 241 beziehungsweise U-förmigen Kontaktbuchsen 251 der rechten und linken elektrischen Kontaktiereinrichtungen 24, 25 kann eine elektrische Isolierung der Stromdurchleitung gewährleistet werden. Die Umfassungen 3121, 3231 im Bereich der rechteckigen Aussparungen 312, 323 für die rechte beziehungsweise linke Datenbuskontaktierung 27, 28 in den Kontaktplatten 31, 32 dienen zur Positionsfixierung der Datenbuskontaktierungen und ermöglichen ein vereinfachtes Anschließen. Die Umfassung 3131, 3221 der Schlitzöffnungen 313 und der Aussparungen 322 und die Umfassungen 3121, 3231 im Bereich der rechteckigen Aussparungen 312, 323 müssen nicht geschlossen ausgebildet sein und können auch als anders gestalteter Eingriff ausgeformt werden. Die Form der Schlitzöffnungen 313 sowie der Aussparungen 312, 322, 323 kann auch variiert werden und als an die jeweilige Funktion angepasste Öffnung ausgestaltet sein.

Die elektronische Reihenklemme ist ausgelegt, um auf eine Tragschiene 14, wie in den Fig. 1 bis 8 gezeigt, aufgesetzt zu werden. In der Basiswanne 11 ist im Rückseitendeckel 114 eine durchgehende U-förmige Einbuchtung vorgesehen, mit der die Basiswanne 11 auf die Trageschiene 14 aufgesetzt werden kann. Am Rückseitendeckel 114 der Basiswanne 11 ist ein Verriegelungssystem 15, das in der Explosionsdarstellung in Fig. 8 gezeigt ist, angeordnet, das sich aus einem beweglich angeordneten unteren Verriegelungselement 151 und einem starr angeordneten oberen Verriegelungselement 152 zusammensetzt. Wenn die Trageschiene 14 in der U-förmige Einbuchtung am Rückseitendeckel 114 der Basiswanne 11 auf dem oberen Verriegelungselement 152 aufliegt, kann das unteren Verriegelungselement 151 in Eingriff mit der Trageschiene 14 gebracht werden, um die Basiswanne 11 an der Trageschiene 14 zu sichern. Fig. 75 zeigt eine Ansicht von unten, bei der die elektronische Reihenklemme auf der Trageschiene 14 aufgesetzt ist und durch das Verriegelungssystem 15 festgehalten wird.

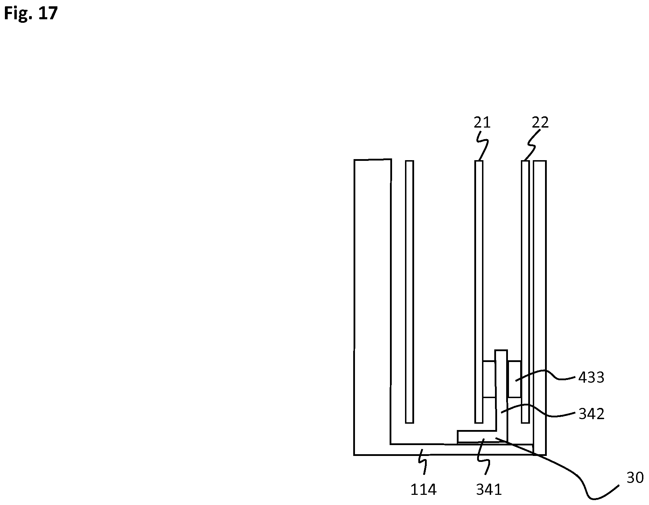

Um für eine verbesserte Wärmeableitung aus der Steuerelektronik 20 zu sorgen, kann in der elektronischen Reihenklemme ferner ein Thermosockel 30 vorgesehen sein, der sich in thermischem Kontakt mit den Leiterkarten 21, 22 der Steuerelektronik 20 befindet und eine Verbindung zum Metallgehäuse 10 herstellt. Fig. 17 zeigt eine Ausführungsform mit einem L-förmigen Thermosockel 30, der am Rückseitendeckel 114 mit einem Fußbereich 341 anliegt und sich zwischen die Leiterkarten 21, 22 der Steuerelektronik mit einem Armbereich 342 erstreckt. Der sich zwischen die Leiterkarten erstreckende Armbereich 342 ist dabei über thermisch leitende Elemente 343, zum Beispiel Thermoleitpasten, mit den Leiterkarten 21, 22 verbunden.

Das Metallgehäuse 10 der elektronischen Reihenklemme weist ferner, wie Fig. 1 bis 7 zeigen, an der oberen und unteren Gehäuse-Seitenfläche 112, 113 der Basiswanne 11 Schraubadapter 41, 42 auf, die an den Lüftungsschlitzgitter 118 angrenzen. An die Schraubadaptern 41, 42 kann ein Kabelhalter 43, wie in den Fig. 1 bis 7 gezeigt, angeschraubt sein, der eine Kabelklemme 44 zum Halten von Kabeln 45 aufweist, über die Signale beziehungsweise Ströme an die elektronische Reihenklemme herangeführt werden können.

In der oberen und unteren Gehäuse-Seitenfläche 112, 113 der Basiswanne 11 sind weiterhin angrenzend an den Rückseitendeckel 114 Eingriffe vorgesehen, in die seitliche Montageflansche 51, 52, wie Fig. 1 zeigt, eingesetzt werden können. Mit den Montageflanschen 51, 52, in denen Schraublöcher ausgeführt sind, kann die elektronische Reihenklemme zusätzlich zum Aufrasten auf die Trageschiene 14 zum Beispiel an einer Schaltschrankrückwand befestigt werden. Die Montageflansche 51, 52 sorgen ferner auch für eine verbesserte Wärmeableitung aus dem Metallgehäuse 10.

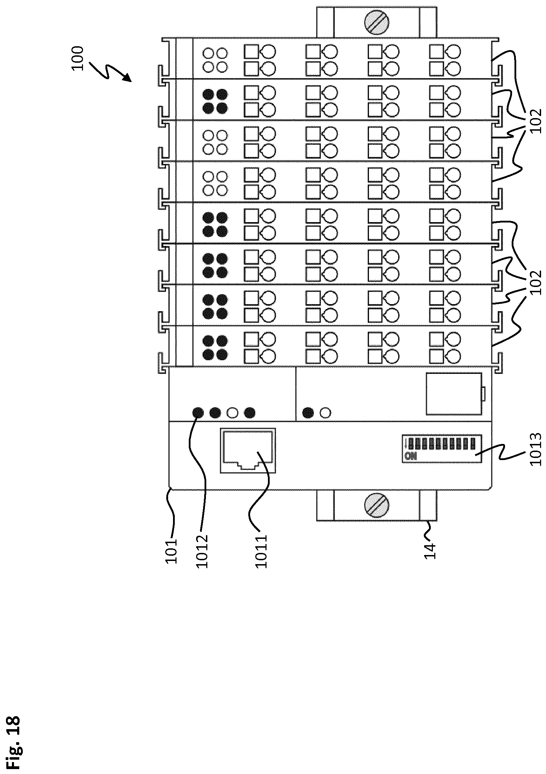

Elektronische Reihenklemmen werden in der Regel zusammen mit anderen Reihenklemmen gemeinsam auf der Trageschiene 14 zusammen angeordnet und bilden eine Busklemmenstation 100, wie sie in Fig. 18 dargestellt ist. Um ein Aneinanderreihen der elektronischen Reihenklemmen zu ermöglichen, sind auf der einen Seite der elektronischen Reihenklemme C-förmige Schienen vorgesehen, die in U-förmige Schlitze auf der anderen Seite der elektronischen Reihenklemme eingreifen.

Bei der elektronischen Reihenklemme, wie sie in den Fig. 1 bis 16 gezeigt ist, mit einem Metallgehäuse 10 und seitlichen Kopplungsplatten 31, 32 sind zwei C-förmigen Schienen 314 an der rechten Kopplungsplatte 31 angeordnet. In der linken Kopplungsplatte 32 sind dann seitlich zwei Schlitze 324 ausgeführt. Die C-förmigen Schienen 314 an der rechten Kopplungsplatte 31 können in die Schlitze 324 der linken Kopplungsplatte 32 beim Aufstecken einer elektronischen Reihenklemme auf eine benachbarte elektronischen Reihenklemme, die bereits auf der Trageschiene 14 aufgerastet ist, eingreifen, um die Busklemmenstation 100 auszubilden. Die Nut-Feder-Verbindung sorgt für einen vereinfachten Aneinanderreihvorgang und sichert den Reihenklemmenverbund zusätzlich zur Verriegelung auf der Trageschiene.

Um beim Aufstecken der elektronischen Reihenklemme auf eine benachbarte elektronische Reihenklemme die aus der rechten Kopplungsplatte 31 vorstehenden Kontaktstifte 241 der ersten elektrischen Kontaktiereinrichtung 24 positionieren zu können, weist die linke Kopplungsplatte 32, wie die Ansicht von außen in Fig. 13 zeigt, Führungsschlitze 325 auf, die parallel zu den Außenkanten der linken Kopplungsplatte 32 verlaufen und die die Aussparungen 322 für die Kontaktbuchsen 251 der zweiten elektrischen Kontaktiereinrichtung 25 umfassen.

Um eine elektrische Reihenklemme in eine Busklemmenstation einzufügen, werden die C-förmigen Schienen 314 der rechten Kopplungsplatte 31 der elektrische Reihenklemme in die Schlitze 324 der linken Kopplungsplatte 32 der benachbarten elektrische Reihenklemme, die bereits auf der Tragschiene aufgerastet ist, eingeführt. Die elektrische Reihenklemme wird dann entlang der benachbarten elektrischen Reihenklemme aufgeschoben, wobei die vorstehenden Kontaktstifte 241 der elektrische Reihenklemme in den Führungsschlitzen 325 der linken Kopplungsplatte 32 der benachbarten elektrische Reihenklemme laufen, bis die elektrische Reihenklemme auf der Trageschiene 14 aufrastet. In der Endposition greifen dann die Kontaktstifte 241 der elektrischen Reihenklemme in die U-förmigen Kontaktbuchsen 251 der benachbarten elektrischen Reihenklemme ein und sorgen so für eine Stromdurchleitung. Mit dieser Auslegung wird dann eine durchgehende elektrische Verbindung geschaffen, so dass die Spannungsversorgung durch die Reihenklemmen in der Busklemmenstation hindurchgeschleift werden kann.

Wenn die elektrische Reihenklemme auf der Trageschiene 14 aufgerastet ist, drücken zugleich die Federdruckbügel 281 der linken Datenbuskontaktierung 28 der benachbarten elektrischen Reihenklemme gegen die Kontaktstege 271 der rechten Datenbuskontaktierung 27 der elektrischen Reihenklemme und stellen so eine durchgehende Datenverbindung her. Der durch die Reihenklemme durchgeschleifte Datenbus ist vorzugsweise ein E- oder K-Bus.

Um einen Potentialausgleich zwischen den elektronischen Busklemmen mit einem Metallgehäuse auch unabhängig von der Tragschiene 14 bereitzustellen, ist ein weiterer Querkontakt 60 vorgesehen, der als Federkontakt ausgebildet sein kann, wie die Explosionsdarstellung in Fig. 8 zeigt. Der Querkontakt 60 ist auf dem Basisdeckel 12 angeordnet und greift durch eine weitere Aussparung 326 in der linken Kopplungsplatte 32, wie die Ansicht von links in Fig. 3 zeigt. In der rechten Kopplungsplatte 31 ist dann auch eine zusätzliche Aussparung 315 vorgesehen, die auf die Aussparung 326 an der linken Kopplungsplatte 32 für den Querkontakt 60 abgestimmt ist, damit der Querkontakt einer benachbarten elektronischen Reihenklemme eingreifen kann, um einen Potentialausgleich herzustellen.

Die in Fig. 18 gezeigte Busklemmenstation 100 weist als Kopfstelle einen Buskoppler 101 und acht daran sich anschließende Reihenklemmen 102 auf. Der Buskoppler 101 besitzt einen Steckplatz 1011 für ein Buskabel (nicht gezeigt), der als RY45-Steckbuchse ausgebildet ist, und dient als Schnittstelle zu einem Feldbus (nicht gezeigt), um die elektronische Reihenklemme an eine Steuereinheit (nicht gezeigt) anzuschließen. Auf der Frontseite des Buskopplers 101 sind LEDs 1012 vorgesehen, die den Betriebszustand anzeigen. Weiterhin weist der Buskoppler 101 einen Adress-Schalter 1013, einen so genannte DIP (Dual Inline Package)-Schalter auf, mit dem sich die Adresse des Buskopplers einstellen lässt.

Die sich an den Buskoppler 101 anschließenden elektronischen Reihenklemmen 102, die den in Fig. 8 gezeigten Reihenklemmen entsprechen, weisen auf der Frontseite im Gegensatz zu der in den Fig. 1 bis 16 gezeigten Reihenklemme statt Steckverbindern Klemmanschlüsse in Cage-Clamp-Technologie zum Anschließen von Aktoren beziehungsweise Sensoren auf. Auch sind bei den elektronischen Reihenklemmen 102 in der in Fig. 18 gezeigten Auslegung auf der Frontseite statt mit dem seitlich entlang der Steckplätze angeordneten LED-Prisma, wie bei der den Fig. 1 bis 16 gezeigten elektronischen Reihenklemme vorgesehen, jeweils mit LED-Einheiten oberhalb der Klemmanschlüsse ausgestattet.

Die Busklemmenstation 100 kann je nach Auslegung der Strom- und Datenverbindung und Bauraumgröße eine beliebige Anzahl von elektronischen Reihenklemmen, die aneinandergesteckt sind, aufweisen. Dabei können unterschiedlich ausgelegte elektronische Reihenklemmen miteinander verbaut werden. So können neben elektronischen Reihenklemmen, wie sie in der Fig. 1 bis 16 gezeigt sind, die Metallgehäuse und seitlichen Kontaktplatten aus dem nicht-metallischen Werkstoff, vorzugsweise elektrischem Isolierstoff aufweisen, auch elektronische Reihenklemmen mit einem reinen Kunststoffgehäuse verwendet werden. Ferner können elektronischen Reihenklemmen mit beliebiger Funktionalität in der Busklemmenstation gemischt angeordnet werden. Jede elektronische Reihenklemme in der Busklemmenstation kann auf einfache Weise durch Herausziehen aus der Busklemmenstation entfernt beziehungsweise durch eine andere elektronische Reihenklemme ersetzt werden.

Auch kann die elektronische Reihenklemme, wenn sie als Endelement eingesetzt wird nur eine seitliche Kontaktplatte aufweisen. Eine elektronische Reihenklemme weist dann eine elektrische Kontaktiereinrichtung, die über die interne Stromleitung verbunden ist, eine Datenbus-Kontaktiereinrichtung, die über die interne Datenbusleitung verbunden ist, auf. Eine Gehäuse-Seitenfläche weist ferner eine erste Öffnung für die Datenbus-Kontaktiereinrichtung und eine zweite Öffnung für die elektrische Kontaktiereinrichtung auf. Es ist weiter eine Kopplungsplatte zum Anbringen auf der Gehäuse-Seitenfläche vorgesehen, die eine erste Aussparung mit einem Eingriff im Bereich der ersten Öffnung der Gehäuse-Seitenfläche und eine zweite Aussparung mit einem Eingriff im Bereich der zweiten Öffnung der Gehäuse-Seitenfläche aufweist. Die Kopplungsplatte ist dabei aus dem nicht-metallischen Werkstoff, vorzugsweise aus dem elektrischen Isolierstoff gefertigt.

### Bezugszeichenliste:

Metallgehäuse 10
Basiswanne 11
rechte Gehäuse-Seitenfläche 111
Einschrauböffnung 1111
rechteckige Öffnung 1112
Durchlass 1113
obere Gehäuse-Seitenfläche 112
untere Gehäuse-Seitenfläche 113
Rückseitendeckel 114
linker Gehäuse-Seitenfläche 115
Einschraubdom 1151
Durchlass 1152
rechteckige Öffnung 1153
Verschraubungsdome für Leiterkarten 116
Verschraubungsdome für Gehäuse 117
Lüftungsschlitzgitter 118
Basisdeckel 12
Frontdeckel 13
Tragschiene 14
Verriegelungssystem 15
unteres Verriegelungselement 151
oberes Verriegelungselement 152
Steuerelektronik 20
rechte Leiterkarte 21
linke Leiterkarte 22
Steckerleiste 23
Steckplätze 231
LED-Prisma 232
rechte elektrische Kontaktiereinrichtung 24
Kontaktstift 241
linke elektrische Kontaktiereinrichtung 25
U-förmige Kontaktbuchse 251
interne Stromleitung 26
U-förmigen Kontaktbuchse 261
Kontaktstift 262
rechte Datenbuskontaktierung 27
Kontaktsteg 271
linke Datenbuskontaktierung 28
Federdruckbügel 281
interne Datenbusleitung 29
rechte Kopplungsplatte 31
Schraubloch 311
rechteckige Aussparung 312
Umfassung 3121
Schlitzöffnung 313
Umfassung 3131
C-förmigen Schiene 314
Aussparung 315 für Querkontakt
linke Kopplungsplatte 32
Schraubloch 321
Aussparung 322 für Kontaktbuchse
Umfassung 3221
rechteckige Aussparung 323
Umfassung 3231
Schlitz 324
Führungsschlitze 325
Aussparung 326 für Querkontakt
Schrauben 33
Thermosockel 30
Fußbereich 341
Armbereich 342
thermisch leitendes Elemente 343
Schraubadapter 41
Schraubadaptern 42
Kabelhalter 43
Kabelklemme 44
Kabeln 45
Montageflansch 51
Montageflansch 52
Querkontakt 60
Busklemmenstation 100
Buskoppler 101
Steckplatz 1011
LED 1012
Adress-Schalter 1013
elektronische Reihenklemme 102

## Patentansprüche

1. Elektronische Reihenklemme für einen Datenbus mit
einer Steuerungselektronik (20), die eine elektrische Kontaktiereinrichtung (24, 25), die über eine interne Stromleitung (26) verbunden sind, eine Datenbus-Kontaktiereinrichtung (27, 28), die über eine interne Datenbusleitung (29) verbunden sind, und eine Anschlusseinrichtung (23) zum Anschließen von Busteilnehmern aufweist,
einem Gehäuse (10), in dem die Steuerungselektronik (20) angeordnet ist und das eine erste Gehäuse-Seite (114) mit einer Aufnahme für eine Trageschiene (14), eine zweite Gehäuse-Seite (13) mit einer Aussparung für die Anschlusseinrichtung (23) der Steuerungselektronik und eine Gehäuse-Seitenfläche (111, 115) aufweist, wobei die Gehäuse-Seitenfläche (111, 115) eine erste Öffnung (1112, 1153) für die Datenbus-Kontaktiereinrichtung (27, 28) der Steuerungselektronik und eine zweite Öffnung (1113, 1152) für die elektrische Kontaktiereinrichtung (24, 25) der Steuerungselektronik aufweist,
**dadurch gekennzeichnet, dass**
das Gehäuse (10) ein Metallgehäuse ist,
wobei eine Kopplungsplatte (31, 32) zum Anbringen auf der Gehäuse-Seitenfläche (111, 115) vorgesehen ist, die eine erste Aussparung (312, 323) mit einem Eingriff (3121, 3131) im Bereich der ersten Öffnung (1112, 1153) der ersten Gehäuse-Seitenfläche und eine zweite Aussparung (313, 322) mit einem Eingriff (3131, 3221) im Bereich der zweiten Öffnung (1113, 1152) der Gehäuse-Seitenfläche aufweist,
wobei die Kopplungsplatte (31, 32) aus einem nicht-metallischen Werkstoff, vorzugsweise einem elektrischen Isolierstoff besteht, und
wobei die Eingriffe (3121, 3131) vorstehende Umfassungen (3131) sind.

2. Elektronische Reihenklemme nach Anspruch 1, wobei eine erste und eine zweite elektrische Kontaktiereinrichtung (24, 25) über die interne Stromleitung (26) verbunden sind, wobei eine erste und eine zweite Datenbus-Kontaktiereinrichtung (27, 28) über die interne Datenbusleitung (29) verbunden sind, wobei eine erste Gehäuse-Seitenfläche (111) eine erste Öffnung (1112) für die erste Datenbus-Kontaktiereinrichtung (27) der Steuerungselektronik und eine zweite Öffnung (1113) für die erste elektrische Kontaktiereinrichtung (24) der Steuerungselektronik aufweist,wobei eine zweite, der ersten Gehäuse-Seitenfläche (111) gegenüberliegende Gehäuse-Seitenfläche (115) eine erste Öffnung (1153) für die zweite Datenbus-Kontaktiereinrichtung (28) der Steuerungselektronik und eine zweite Öffnung (1152) für die zweite elektrische Kontaktiereinrichtung (25) der Steuerungselektronik aufweist,
wobei eine ersten Kopplungsplatte (31) zum Anbringen auf der ersten Gehäuse-Seitenfläche (111) eine erste Aussparung (312) mit einem Eingriff (3121) im Bereich der ersten Öffnung (1112) der ersten Gehäuse-Seitenfläche und eine zweite Aussparung (313) mit einem Eingriff (3131) im Bereich der zweiten Öffnung (1113) der ersten Gehäuse-Seitenfläche aufweist, wobei eine zweite Kopplungsplatte (32) zum Anbringen auf der zweiten Gehäuse-Seitenfläche (115) eine erste Aussparung (323) mit einem Eingriff (3231) im Bereich der ersten Öffnung (1153) der zweiten Gehäuse-Seitenfläche und eine zweite Aussparung (322) mit einem Eingriff (3221) im Bereich der zweiten Öffnung (1152) der zweiten Gehäuse-Seitenfläche aufweist, wobei die erste und die zweite Kopplungsplatte (31, 32) aus dem nicht-metallischen Werkstoff, vorzugsweise dem elektrischen Isolierstoff bestehen, und
wobei die Eingriffe (3121, 3131, 3221, 3231) vorstehende Umfassungen (3131) sind.

3. Elektronische Reihenklemme nach Anspruch 2, wobei die erste Kopplungsplatte (31) zwei seitlich vorstehende C-förmige Schienen (314) zum Eingriff in Schlitze und die zweite Kopplungsplatte zwei seitliche Schlitze (324) zum Eingriff von C-förmigen Schienen aufweist.

4. Elektronische Reihenklemme nach Anspruch 2 oder 3, wobei die erste elektrische Kontaktiereinrichtung (24) wenigstens einen Kontaktstift (241) und die zweite elektrische Kontaktiereinrichtung (25) wenigstens eine Kontaktöffnung (251) aufweist, wobei der Eingriff (3131) der zweiten Aussparung (313) der ersten Kopplungsplatte (31) sich zwischen dem Kontaktstift und der zweiten Öffnung (1113) der ersten Gehäuse-Seitenfläche erstreckt, und wobei der Eingriff (3221) der zweiten Aussparung (322) der zweiten Kopplungsplatte sich zwischen der Kontaktöffnung und der zweiten Öffnung (1152) der zweiten Gehäuse-Seitenfläche (115) erstreckt.

5. Elektronische Reihenklemme nach Anspruch 4, wobei die zweiten Aussparung (322) der zweiten Kopplungsplatte (32) ein Schlitzloch in einem außen quer über die Kontaktplatte verlaufenden Führungsschlitz (325) ist.

6. Elektronische Reihenklemme nach einem der Ansprüche 2 bis 5, wobei der Eingriff (3121) der ersten Aussparung (312) der ersten Kopplungsplatte (31) die erste Datenbus-Kontaktiereinrichtung (27) der Steuerungselektronik (20) und der Eingriff (3231) der ersten Aussparung (323) der zweiten Kopplungsplatte (32) die zweite Datenbus-Kontaktiereinrichtung (28) der Steuerungselektronik (20) fixiert.

7. Elektronische Reihenklemme nach Anspruch 6, wobei die erste und die zweite Datenbus-Kontaktiereinrichtung (27, 28) einen Federkraft-Busanschluss bilden, der wenigstens eine nach außen weisende Kontaktfeder (281) und eine zugeordnete Kontaktfläche (271) aufweist.

8. Elektronische Reihenklemme nach einem der Ansprüche 2 bis 7, wobei die erste und die zweite Kopplungsplatte (31, 32) jeweils eine dritte Aussparung (315, 326) zum Eingriff eines Querkontaktes (60) auf der zugeordneten Gehäuse-Seitenfläche aufweist.

9. Elektronische Reihenklemme nach einem der Ansprüche 1 bis 8, wobei ein Thermosockel (30) vorgesehen ist, der sich in thermischem Kontakt mit der Steuerelektronik (20) befindet und die Steuerungselektronik (20) mit dem Metallgehäuse (10) verbindet.

10. Elektronische Reihenklemme nach einem der Ansprüche 1 bis 9, wobei in zwei sich gegenüber liegenden Gehäuse-Seitenflächen (112, 113) jeweils wenigstens ein Lüftungsfenster (118) vorgesehen ist.

11. Elektronische Reihenklemme nach einem der Ansprüche 1 bis 10, wobei zwei die Gehäuse-Seite (114) mit der Aufnahme für die Trageschiene (14) verlängernde, sich gegenüberliegende thermisch leitende Montageflansche (51, 52) vorgesehen sind.

12. Elektronische Reihenklemme nach einem der Ansprüche 1 bis 11, wobei an der Gehäuse-Seite (13) mit der Aussparung für die Anschlusseinrichtung (23) angrenzend wenigstens ein Schraubadapter (41, 42) vorgesehen ist.

13. Elektronische Reihenklemme nach einem der Ansprüche 1 bis 12, wobei das Metallgehäuse (10) aus Guss oder gefräst ist.

14. Elektronische Reihenklemme nach einem der Ansprüche 1 bis 12, wobei das Metallgehäuse (10) mit einem 3D-Verfahren gefertigt wird.

15. Busklemmenstation aufweisend einen Buskoppler und mehrere elektronische Reihenklemmen, die nebeneinander auf einer Trageschiene (14) anordenbar sind, wobei eine elektronische Reihenklemme nach einem der Ansprüche 1 bis 14 ausgebildet ist.

## Claims

1. Electronic terminal block for a data bus having
a control electronics system (20), which has an electrical contact-making device (24, 25), which is connected via an internal power line (26), a data bus contact-making device (27, 28), which is connected via an internal data bus line (29), and a connection device (23) for connecting bus subscribers,
a housing (10), in which the control electronics system (20) is arranged and which has a first housing side (114) having a receptacle for a support rail (14), a second housing side (13) having a recess for the connection device (23) of the control electronics system and a housing side face (111, 115), wherein the housing side face (111, 115) has a first opening (1112, 1153) for the data bus contact-making device (27, 28) of the control electronics system and a second opening (1113, 1152) for the electrical contact-making device (24, 25) of the control electronics system,
**characterized in that**
the housing (10) is a metal housing,
wherein a coupling plate (31, 32) is provided for mounting on the housing side face (111, 115), said coupling plate having a first recess (312, 323) having an engagement area (3121, 3131) in the region of the first opening (1112, 1153) of the first housing side face and a second recess (313, 322) having an engagement area (3131, 3221) in the region of the second opening (1113, 1152) of the housing side face,
wherein the coupling plate (31, 32) is made of a non-metallic material, preferably an electrical insulating material, and
wherein the engagement areas (3121, 3131) are projecting surrounds (3131).

2. Electronic terminal block according to Claim 1, wherein a first and a second electrical contact-making device (24, 25) are connected via the internal power line (26), wherein a first and a second data bus contact-making device (27, 28) are connected via the internal data bus line (29), wherein a first housing side face (111) has a first opening (1112) for the first data bus contact-making device (27) of the control electronics system and a second opening (1113) for the first electrical contact-making device (24) of the control electronics system, wherein a second housing side face (115) opposite the first housing side face (111) has a first opening (1153) for the second data bus contact-making device (28) of the control electronics system and a second opening (1152) for the second electrical contact-making device (25) of the control electronics system,
wherein a first coupling plate (31) for mounting on the first housing side face (111) has a first recess (312) having an engagement area (3121) in the region of the first opening (1112) of the first housing side face and a second recess (313) having an engagement area (3131) in the region of the second opening (1113) of the first housing side face, wherein a second coupling plate (32) for mounting on the second housing side face (115) has a first recess (323) having an engagement area (3231) in the region of the first opening (1153) of the second housing side face and a second recess (322) having an engagement area (3221) in the region of the second opening (1152) of the second housing side face, wherein the first and the second coupling plate (31, 32) are made of the non-metallic material, preferably the electrical insulating material, and
wherein the engagement areas (3121, 3131, 3221, 3231) are projecting surrounds (3131).

3. Electronic terminal block according to Claim 2, wherein the first coupling plate (31) has two laterally projecting C-shaped rails (314) for engagement into slots and the second coupling plate has two lateral slots (324) for the engagement of C-shaped rails.

4. Electronic terminal block according to Claim 2 or 3, wherein the first electrical contact-making device (24) has at least one contact pin (241) and the second electrical contact-making device (25) has at least one contact opening (251), wherein the engagement area (3131) of the second recess (313) of the first coupling plate (31) extends between the contact pin and the second opening (1113) of the first housing side face, and wherein the engagement area (3221) of the second recess (322) of the second coupling plate extends between the contact opening and the second opening (1152) of the second housing side face (115).

5. Electronic terminal block according to Claim 4, wherein the second recess (322) of the second coupling plate (32) is a slotted hole in a guide slot (325) that runs externally transversely over the contact plate.

6. Electronic terminal block according to one of Claims 2 to 5, wherein the engagement area (3121) of the first recess (312) of the first coupling plate (31) fixes the first data bus contact-making device (27) of the control electronics system (20) and the engagement area (3231) of the first recess (323) of the second coupling plate (32) fixes the second data bus contact-making device (28) of the control electronics system (20).

7. Electronic terminal block according to Claim 6, wherein the first and the second data bus contact-making device (27, 28) form a spring-force bus connection, which has at least one contact spring (281) facing outwards and an associated contact face (271).

8. Electronic terminal block according to one of Claims 2 to 7, wherein the first and the second coupling plate (31, 32) each have a third recess (315, 326) for engagement of a transverse contact (60) on the associated housing side face.

9. Electronic terminal block according to one of Claims 1 to 8, wherein a thermal socket (30) is provided, which is in thermal contact with the control electronics system (20) and which connects the control electronics system (20) to the metal housing (10).

10. Electronic terminal block according to one of Claims 1 to 9, wherein in each case at least one ventilation window (118) is provided in two opposite housing side faces (112, 113).

11. Electronic terminal block according to one of Claims 1 to 10, wherein two opposite, thermally conductive mounting flanges (51, 52), which extend the housing side (114) having the receptacle for the support rail (14), are provided.

12. Electronic terminal block according to one of Claims 1 to 11, wherein at least one screw adapter (41, 42) is provided adjoining the housing side (13) having the recess for the connection device (23).

13. Electronic terminal block according to one of Claims 1 to 12, wherein the metal housing (10) is cast or is milled.

14. Electronic terminal block according to one of Claims 1 to 12, wherein the metal housing (10) is produced by way of a 3D method.

15. Bus terminal station having a bus coupler and a plurality of electronic terminal blocks, which are able to be arranged next one another on a support rail (14), wherein an electronic terminal block is configured according to one of Claims 1 to 14.

## Revendications

1. Bloc de jonction électronique pour un bus de données, comprenant
une électronique de commande (20) qui comprend un dispositif de mise en contact électrique (24, 25) qui est connecté par le biais d'une ligne électrique interne (26), un dispositif de mise en contact (27, 28) de bus de données qui est connecté par le biais d'une ligne interne (29) de bus de données, et un dispositif de connexion (23) pour la connexion d'abonnés de bus,
un boîtier (10) dans lequel l'électronique de commande (20) est disposée et qui comprend un premier côté de boîtier (114) doté d'un logement pour un profilé support (14), un deuxième côté de boîtier (13) doté d'un évidement pour le dispositif de connexion (23) de l'électronique de commande et une face latérale de boîtier (111, 115), dans lequel la face latérale de boîtier (111, 115) comprend une première ouverture (1112, 1153) pour le dispositif de mise en contact (27, 28) de bus de données de l'électronique de commande et une deuxième ouverture (1113, 1152) pour le dispositif de mise en contact électrique (24, 25) de l'électronique de commande,
**caractérisé en ce que**
le boîtier (10) est un boîtier métallique,
une plaque d'accouplement (31, 32) étant prévue pour le montage sur la face latérale de boîtier (111, 115), laquelle plaque comprend un premier évidement (312, 323) doté d'un élément d'entrée en prise (3121, 3131) dans la région de la première ouverture (1112, 1153) de la première face latérale de boîtier et un deuxième évidement (313, 322) doté d'un élément d'entrée en prise (3131, 3221) dans la région de la deuxième ouverture (1113, 1152) de la face latérale de boîtier,
la plaque d'accouplement (31, 32) étant constituée d'une matière non métallique, de préférence d'un isolant électrique et
les éléments d'entrée en prise (3121, 3131) étant des enceintes saillantes (3131).

2. Bloc de jonction électronique selon la revendication 1, dans lequel un premier et un deuxième dispositif de mise en contact électrique (24, 25) sont connectés par le biais de la ligne électrique interne (26), dans lequel un premier et un deuxième dispositif de mise en contact (27, 28) de bus de données sont connectés par le biais de la ligne interne (29) de bus de données, dans lequel une première face latérale de boîtier (111) comprend une première ouverture (1112) pour le premier dispositif de mise en contact (27) de bus de données de l'électronique de commande et une deuxième ouverture (1113) pour le premier dispositif de mise en contact électrique (24) de l'électronique de commande, dans lequel une deuxième face latérale de boîtier (115) en regard de la première face latérale de boîtier (111) comprend une première ouverture (1153) pour le deuxième dispositif de mise en contact (28) de bus de données de l'électronique de commande et une deuxième ouverture (1152) pour le deuxième dispositif de mise en contact électrique (25) de l'électronique de commande,
dans lequel une première plaque d'accouplement (31) pour le montage sur la première face latérale de boîtier (111) comprend un premier évidement (312) doté d'un élément d'entrée en prise (3121) dans la région de la première ouverture (1112) de la première face latérale de boîtier et un deuxième évidement (313) doté d'un élément d'entrée en prise (3131) dans la région de la deuxième ouverture (1113) de la première face latérale de boîtier,
dans lequel une deuxième plaque d'accouplement (32) pour le montage sur la deuxième face latérale de boîtier (115) comprend un premier évidement (323) doté d'un élément d'entrée en prise (3231) dans la région de la première ouverture (1153) de la deuxième face latérale de boîtier et un deuxième évidement (322) doté d'un élément d'entrée en prise (3221) dans la région de la deuxième ouverture (1152) de la deuxième face latérale de boîtier,
dans lequel la première et la deuxième plaque d'accouplement (31, 32) sont constituées de la matière non métallique, de préférence de l'isolant électrique et dans lequel les éléments d'entrée en prise (3121, 3131, 3221, 3231) sont des enceintes saillantes (3131).

3. Bloc de jonction électronique selon la revendication 2, dans lequel la première plaque d'accouplement (31) comprend deux rails (314) en forme de C faisant saillie latéralement destinés à venir en prise dans des fentes et la deuxième plaque d'accouplement comprend deux fentes latérales (324) pour l'entrée en prise de rails en forme de C.

4. Bloc de jonction électronique selon la revendication 2 ou 3, dans lequel le premier dispositif de mise en contact électrique (24) comprend au moins une broche de contact (241) et le deuxième dispositif de mise en contact électrique (25) comprend au moins une ouverture de contact (251), dans lequel l'élément d'entrée en prise (3131) du deuxième évidement (313) de la première plaque d'accouplement (31) s'étend entre la broche de contact et la deuxième ouverture (1113) de la première face latérale de boîtier, et dans lequel l'élément d'entrée en prise (3221) du deuxième évidement (322) de la deuxième plaque d'accouplement s'étend entre l'ouverture de contact et la deuxième ouverture (1152) de la deuxième face latérale de boîtier (115).

5. Bloc de jonction électronique selon la revendication 4, dans lequel le deuxième évidement (322) de la deuxième plaque d'accouplement (32) est un trou en fente dans une fente de guidage (325) s'étendant à l'extérieur transversalement sur la plaque de contact.

6. Bloc de jonction électronique selon l'une des revendications 2 à 5, dans lequel l'élément d'entrée en prise (3121) du premier évidement (312) de la première plaque d'accouplement (31) fixe le premier dispositif de mise en contact (27) de bus de données de l'électronique de commande (20) et l'élément d'entrée en prise (3231) du premier évidement (323) de la deuxième plaque d'accouplement (32) fixe le deuxième dispositif de mise en contact (28) de bus de données de l'électronique de commande (20).

7. Bloc de jonction électronique selon la revendication 6, dans lequel le premier et le deuxième dispositif de mise en contact (27, 28) de bus de données forment une borne de bus à force de ressort, laquelle borne de bus comprend au moins un ressort de contact (281) tourné vers l'extérieur et une face de contact associée (271).

8. Bloc de jonction électronique selon l'une des revendications 2 à 7, dans lequel la première et la deuxième plaque d'accouplement (31, 32) comprennent respectivement un troisième évidement (315, 326) pour l'entrée en prise d'un contact transversal (60) sur la face latérale de boîtier associée.

9. Bloc de jonction électronique selon l'une des revendications 1 à 8, dans lequel une base thermique (30) est prévue, laquelle se trouve en contact thermique avec l'électronique de commande (20) et connecte l'électronique de commande (20) au boîtier métallique (10) .

10. Bloc de jonction électronique selon l'une des revendications 1 à 9, dans lequel respectivement au moins une fenêtre d'aération (118) est prévue dans deux faces latérales de boîtier (112, 113) se faisant face.

11. Bloc de jonction électronique selon l'une des revendications 1 à 10, dans lequel deux brides de montage thermoconductrices (51, 52) opposées prolongeant le côté de boîtier (114) doté du logement pour le profilé support (14) sont prévues.

12. Bloc de jonction électronique selon l'une des revendications 1 à 11, dans lequel au moins un adaptateur fileté (41, 42) est prévu de manière adjacente au côté de boîtier (13) doté de l'évidement pour le dispositif de connexion (23).

13. Bloc de jonction électronique selon l'une des revendications 1 à 12, dans lequel le boîtier métallique (10) est constitué de fonte ou est fraisé.

14. Bloc de jonction électronique selon l'une des revendications 1 à 12, dans lequel le boîtier métallique (10) est fabriqué suivant un procédé 3D.

15. Station de bornes de bus comprenant un coupleur de bus et plusieurs blocs de jonction électroniques qui peuvent être disposés les uns à côté des autres sur un profilé support (14), dans laquelle un bloc de jonction électronique est réalisé selon l'une des revendications 1 à 14.
